# EUROPÄISCHE PATENTSCHRIFT

(11) **EP 3 785 492 B1**
(45) Veröffentlichungstag und Bekanntmachung des Hinweises auf die Patenterteilung: **05.06.2024**
(21) Anmeldenummer: 19718140.7
(22) Anmeldetag: 12.04.2019
(51) Int. Cl.: H05B 45/10, H05B 45/3725

(54) **VERSORGUNGSSCHALTUNG UND VERFAHREN ZUR VERSORGUNG EINER ELEKTRISCHEN LAST**
SUPPLY CIRCUIT AND METHOD FOR SUPPLYING AN ELECTRICAL LOAD
CIRCUIT D'ALIMENTATION ET PROCÉDÉ D'ALIMENTATION D'UNE CHARGE ÉLECTRIQUE

(30) Priorität: 23.04.2018 DE 102018206205
(43) Veröffentlichungstag der Anmeldung: 03.03.2021
(73) Patentinhaber: Tridonic GmbH & Co. KG, 6851 Dornbirn (AT)
(72) Erfinder: MITTERBACHER, Andre, 6850 Dornbirn (AT)
(74) Vertreter: Kraus & Lederer PartGmbB
(86) Internationale Anmeldenummer: PCT/EP2019/059442
(87) Internationale Veröffentlichungsnummer: WO 2019/206680

(56) Entgegenhaltungen:
- EP-A1- 2 230 885
- WO-A1-2008/000465
- WO-A2-2013/067563
- DE-A1- 10 357 776
- DE-A1-102012 007 477
- DE-A1-102016 110 671
- DE-U1-202016 007 619
- DE-U1-202016 007 619
- US-A- 5 345 233
- US-A1- 2013 063 291

## Beschreibung

### TECHNISCHES GEBIET

Die vorliegende Erfindung betrifft Vorrichtungen und Verfahren zur Versorgung einer elektrischen Last, z.B. in Form eines Leuchtmittels.

### HINTERGRUND

Zum Betrieb von auf Leuchtdioden (LED) basierenden Leuchtmitteln, nachfolgend als LED-Leuchtmittel bezeichnet, werden typischerweise Versorgungsschaltungen verwendet, welche aus einer landestypischen Netzspannung, beispielweise eine Wechselspannung von 230V oder 120V, ein für den Betrieb der Leuchtdioden geeignetes Versorgungssignal erzeugen. Dieses Versorgungssignal kann beispielsweise als Gleichstromsignal oder Gleichspannungssignal erzeugt werden. Zu diesem Zweck kann die Versorgungsschaltung einen Schaltregler umfassen, z.B. einen Aufwärtswandler oder einen Abwärtswandler oder einen LLC-Resonanzwandler.

Zum Dimmen eines LED-Leuchtmittels kann eine Versorgungsleistung des LED-Leuchtmittels durch Pulsweitenmodulation des Versorgungssignals gesteuert werden. Hierbei liegt das Versorgungssignal nicht kontinuierlich, sondern pulsweise an dem LED-Leuchtmittel an. Durch verkürzen der Pulsweite wird die Versorgungsleistung reduziert und die von dem LED-Leuchtmittel abgegebene Lichtmenge verringert sich entsprechend. Gleichzeitig kann während der Pulse ein Betrieb des LED-Leuchtmittels in einem bevorzugten Strom- und Spannungsbereich gewährleistet werden. Typische Frequenzen für die Pulsweitenmodulation liegen bei über 500 Hz, müssen jedoch deutlich unter der Frequenz des zur Erzeugung des Versorgungssignals verwendeten Schaltreglers liegen.

Die für die Pulsweitenmodulation genutzten Frequenzen werden üblicherweise möglichst hoch gewählt, um ein für das menschliche Auge wahrnehmbares Flackern zu vermeiden. Bei niedrigen Frequenzen kann es zudem auch zu unerwünschten Störgeräuschen kommen.

Für eine Steuerung der Versorgungsleistung mit höherer Auflösung ist es jedoch erforderlich die Frequenz der Pulsweitenmodulation zu verringern. Es ist daher problematisch ein hochauflösendes Dimmen bei gleichzeitiger Vermeidung von sichtbarem Flackern zu erreichen. Ein weiteres mit der Pulsweitenmodulation einhergehendes Problem besteht darin, dass bei der Frequenz der Pulsweitenmodulation vermehrt elektrische Störungen erzeugt werden.

Es besteht somit ein Bedarf für Technologien, durch welche auf effiziente und störungsarme Weise eine Anpassung der Versorgungsleistung für eine elektrische Last vorgenommen werden kann.

Die DE 103 57 776 A1 beschreibt eine Steueranordnung, bei welcher die Helligkeit einer Leuchtdiode gesteuert wird, indem ein mit der Leuchtdiode gekoppelter Schalter über einen Sigma-Delta-Modulator angesteuert wird.

Die DE 10 2012 007477 A1 beschreibt einen LLC-Resonanzwandler mit einer Halbrücke, die durch einen ersten Schalter und einen zweiten Schalter gebildet ist. Die Schalter können durch MOS-Feldeffekttransistoren gebildet sein.

### ZUSAMMENFASSUNG

Gemäß der vorliegenden Erfindung werden eine Versorgungsschaltung gemäß Anspruch 1 und ein Verfahren gemäß Anspruch 7 bereitgestellt. Die abhängigen Ansprüche definieren weitere Ausführungsbeispiele.

Gemäß einem Ausführungsbeispiel ist somit eine Versorgungsschaltung für eine elektrische Last vorgesehen. Bei der elektrischen Last kann es sich um ein Leuchtmittel, insbesondere ein LED-Leuchtmittel handeln. Die Versorgungsschaltung umfasst eine Wandlerschaltung zur Erzeugung eines Versorgungsignals für die elektrische Last durch Umschalten zwischen verschiedenen Zuständen der Wandlerschaltung. Die Wandlerschaltung ist als LC-, LLC- oder LCC-Resonanzwandler ausgestaltet und umfasst ein Netzwerk und eine Wandlersteuerung. Die Wandlerschaltung umfasst MOS-Transistoren, welche in einer Halbbrückenschaltung angeordnet sind und durch Steuersignale der Wandlersteuerung auf Basis eines ersten Takts gesteuert sind. Weiterhin umfasst die Versorgungsschaltung eine Steuerschaltung zur Steuerung einer Versorgungsleistung der elektrischen Last durch Pulsmodulation des Versorgungssignals. Wenn die elektrische Last ein Leuchtmittel umfasst, kann die Steuerung der Versorgungsleistung einem Dimmen des Leuchtmittels dienen.

Die Steuerschaltung umfasst einen Sigma-Delta-Modulator. Der Sigma-Delta-Modulator ist dazu ausgestaltet, abhängig von einem Eingangssignal, welches einen Zielwert für die Versorgungsleistung vorgibt, ein Pulssequenzsignal zur Steuerung der Pulsmodulation des Versorgungsignals zu erzeugen. Das durch den Sigma-Delta-Modulator erzeugte Pulssequenzsignal steuert die MOS-Transistoren der Wandlerschaltung. Aufgrund der Arbeitsweise des Sigma-Delta-Modulators wird die Versorgungsleistung über eine Dichte von Pulsen in dem Pulssequenzsignal erzeugt: Für einen hohen Zielwert der Versorgungsleistung erzeugt der Sigma-Delta-Modulator das Pulssequenzsignal mit eine hohen Dichte von Pulsen. Für einen niedrigeren Zielwert der Versorgungsleistung erzeugt der Sigma-Delta-Modulator das Pulssequenzsignal mit einer entsprechend geringeren Dichte von Pulsen. Die Frequenz der Pulse in dem Pulssequenzsignal ist somit variabel. Auf diese Weise kann erreicht werden, dass eine hochauflösende Steuerung der Versorgungsleistung möglich ist, während zugleich niederfrequente Störungen begrenzt werden können.

Gemäß einem Ausführungsbeispiel ist der Sigma-Delta-Modulator dazu ausgestaltet, das Pulssequenzsignal auf Basis eines zweiten Taktsignals mit einer niedrigeren Frequenz als das erste Taktsignal zu erzeugen. Hierbei kann die Frequenz des zweiten Taktsignals mehr als ein Zehntel der Frequenz des ersten Taktsignals betragen. Beispielsweise kann die Frequenz des zweiten Taktsignals im Bereich von 10kHz bis 500kHz liegen, während die Frequenz des ersten Taktsignals 1MHz oder mehr betragen kann. Im Vergleich zur Frequenz einer herkömmlichen Pulsweitenmodulation, kann der Sigma-Delta-Modulator somit näher an der Frequenz der Wandlerschaltung betrieben werden, so dass eine verbesserte Vermeidung von Störungen im Bereich niedriger Frequenzen ermöglicht wird.

Das Eingangssignal ist ein digitales Signal. Die Steuerung der Versorgungsleistung kann somit auf direkte Weise über Digitalelektronik erfolgen. Weiterhin wird eine vollständig digitale Implementierung des Sigma-Delta-Modulators ermöglicht, ohne dass eine Analog-Digital-Wandlung am Eingang des Sigma-Delta-Modulators erforderlich ist. Eine Rückkopplungsschleife des Sigma-Delta-Modulators weist eine Verstärkung auf, welche an eine Bittiefe des Eingangssignals angepasst ist.

Gemäß einem Ausführungsbeispiel ist der Sigma-Delta-Modulator mehrstufig, z.B. ein Sigma-Delta-Modulator zweiter oder höherer Ordnung. Hierdurch kann eine weiter verbesserte Vermeidung von Störungen im Bereich niedriger Frequenzen erreicht werden.

Wie oben erwähnt ist die Wandlerschaltung als LC-, LLC- oder LCC-Resonanzwandler ausgestaltet. Auf diese Weise wird ein Betrieb der Wandlerschaltung im Bereich hoher Frequenzen, z.B. 1MHz oder mehr, ermöglicht. Hierdurch kann wiederum auch der Sigma-Delta-Modulator bei höheren Frequenzen betrieben werden und eine weiter verbesserte Vermeidung von Störungen im Bereich niedriger Frequenzen erreicht werden. Alternativ kann die jedoch auch als ein Aufwärtswandler oder einen Abwärtswandler ausgestaltet sein.

Gemäß einem weiteren Ausführungsbeispiel wird ein Verfahren zur Versorgung einer elektrischen Last bereitgestellt, welches mittels der oben beschriebenen Versorgungsschaltung ausgeführt wird. Gemäß dem Verfahren wird ein Versorgungssignal für die elektrische Last durch die Wandlerschaltung erzeugt. Die Versorgungsleistung der elektrischen Last wird durch Pulsmodulation des Versorgungssignals gesteuert. Das Pulssequenzsignal wird erzeugt durch Sigma-Delta-Modulation des Eingangssignals, welches den Zielwert für die Versorgungsleistung vorgibt, und die Pulsmodulation des Versorgungsignals wird gemäß dem Pulssequenzsignal gesteuert, wobei das Pulssequenzsignal die MOS-Transistoren der Wandlerschaltung steuert. Bei dem Verfahren ist das Eingangssignal ist ein digitales Signal. Die Sigma-Delta-Modulation erfolgt durch den Sigma-Delta-Modulator. Die Rückkopplungsschleife des Sigma-Delta-Modulators weist eine Verstärkung auf, die an eine Bittiefe des Eingangssignals angepasst ist.

Auch bei dem Verfahren kann die elektrische Last ein Leuchtmittel umfassen. In diesem Fall kann die Steuerung der Versorgungsleistung ein Dimmen des Leuchtmittels bewirken.

Die oben dargelegten Merkmale und Merkmale, die nachfolgend detaillierter beschrieben werden, können nicht nur in den entsprechenden explizit dargelegten Kombinationen verwendet werden, sondern auch in weiteren Kombinationen oder isoliert.

### KURZE BESCHREIBUNG DER FIGUREN

Nachfolgend wird die vorliegende Erfindung anhand bevorzugter Ausführungsbeispiele unter Bezugnahme auf die Figuren näher erläutert.
Figur 1 veranschaulicht schematisch eine Versorgungsschaltung gemäß einem Ausführungsbeispiel.
Figur 2 veranschaulicht schematisch einen Sigma-Delta-Modulator in einer Steuerschaltung gemäß einem Ausführungsbeispiel.
Figur 3A veranschaulicht schematisch eine Implementierung der Wandlerschaltung der Versorgungsschaltung.
Figur 3B veranschaulicht schematisch eine weitere Implementierung der Wandlerschaltung der Versorgungsschaltung.
Figur 4A und 4B veranschaulichen schematisch weitere Beispiele für einen Sigma-Delta-Modulator in einer Steuerschaltung gemäß einem Ausführungsbeispiel.
Figur 5 zeigt ein Flussdiagramm zur Veranschaulichung eines Verfahrens gemäß einem Ausführungsbeispiel.

### DETAILLIERTE BESCHREIBUNG VON AUSFÜHRUNGSBEISPIELEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden.

Die nachfolgend erläuterten Ausführungsbeispiele beziehen sich auf Versorgungsschaltungen für ein Leuchtmittel, insbesondere ein LED-Leuchtmittel. Es versteht sich jedoch, dass ähnliche Versorgungschaltungen auch für andere Arten von Leuchtmitteln, z.B. Halogenleuchtmittel, oder andere elektrische Lasten, z.B. Elektromotoren, eingesetzt werden könnten,

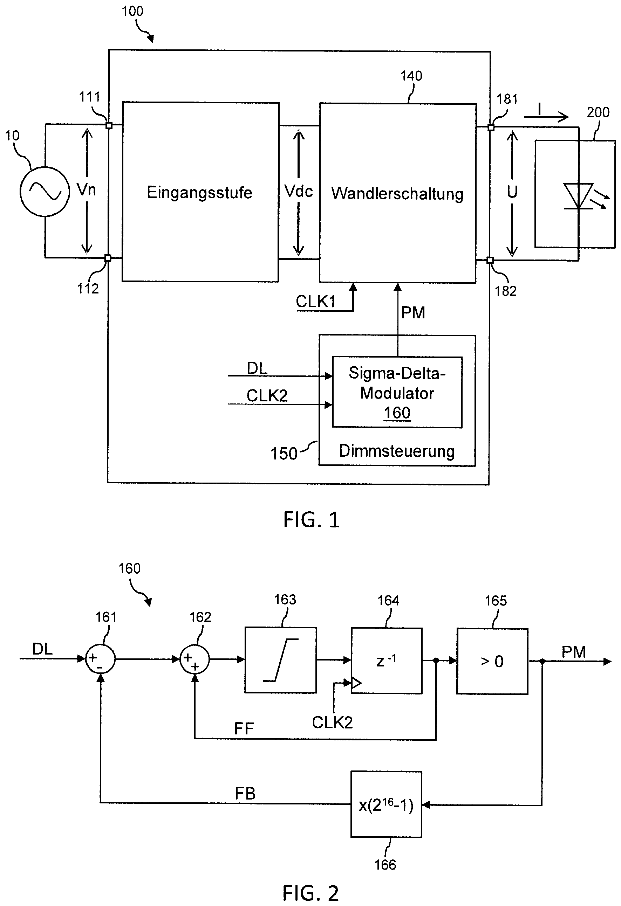

Figur 1 zeigt eine Versorgungsschaltung 100, welche ein LED-Leuchtmittel 200 versorgt. Die Versorgungsschaltung 100 verfügt über Eingänge 111, 112 zur Aufnahme einer Netzspannung Vn. Bei der Netzspannung Vn handelt es sich um eine Wechselspannung, z.B. mit einem landestypischen Effektivwert von 230V oder 120V. Weiterhin verfügt die Versorgungsschaltung 100 über eine Eingangsstufe 120. Die Eingangsstufe erzeugt aus der Netzspannung Vn eine Gleichspannung Vdc. Die von der Eingangsstufe 120 erzeugte Gleichspannung Vdc weist einen Spannungspegel auf, welcher niedriger als der Effektivwert der Netzspannung Vn ist. Beispielsweise kann die Gleichspannung Vdc mit einem Spannungspegel von etwa 60V erzeugt werden. Hierzu kann in der Eingangsstufe 120 z.B. einen Transformator, einen Brückenwandler und/oder einen Abwärtswandler aufweisen. Alternativ kann die Gleichspannung Vdc auch mit einem Spannungspegel erzeugt werden, der über dem Effektivwert der Netzspannung liegt, z.B. über einen Aufwärtswandler der Eingangsstufe 120.

Die Versorgungsschaltung 100 verfügt weiterhin über eine Wandlerschaltung 140. Die Wandlerschaltung ist dazu ausgestaltet, aus der Gleichspannung Vdc jeweils ein für das LED-Leuchtmittel 200 geeignetes Versorgungssignal zu erzeugen, welches an Versorgungsausgängen 181, 182 der Versorgungsschaltung 100 anliegt. Bei dem dargestellten Beispiel wird davon ausgegangen, dass das Versorgungsignal einem Gleichstrom I mit vorgegebenem Strompegel ist, der über die Wandlerschaltung geregelt wird. Es wäre jedoch auch möglich, das Versorgungssignal als Gleichspannung U mit vorgegebenem Spannungspegel zu erzeugen. Wie nachfolgend näher erläutert, ist die Wandlerschaltung 140 als LC-, LLC- oder LCC-Resonanzwandler ausgestaltet. Die Wandlerschaltung wird auf Basis eines ersten Taktsignals CLK1 betrieben. Das erste Taktsignal CLK1 kann der Wandlerschaltung 140 von einer Taktsignalquelle, z.B. einem Oszillator, zugeführt werden. Wie nachfolgend erläutert, ist es jedoch auch möglich, dass das erste Taktsignal CLK1 durch Eigenresonanz innerhalb der Wandlerschaltung 140 erzeugt wird. Die Frequenz des ersten Taktsignals CLK1 kann im Bereich von 1MHz oder mehr liegen. Niedrigere Frequenzen im Bereich einiger 100kHz sind jedoch ebenfalls möglich.

Weiterhin umfasst die Versorgungsschaltung 100 eine Steuerschaltung 150 zur Steuerung einer über das Versorgungssignal bereitgestellten Versorgungsleistung des LED-Leuchtmittels 200. Bei dem dargestellten Beispiel wird diese Steuerung der Versorgungsleistung genutzt, um ein Dimmen des LED-Leuchtmittels 200 zu bewirken. Die Steuerschaltung 150 wird daher im Folgenden auch als Dimmsteuerung bezeichnet. Die Steuerung der Versorgungsleistung erfolgt durch Pulsmodulation gemäß einem Pulssequenzsignal PM. Das Pulssequenzsignal PM kann entweder einen hohen Pegel oder einen niedrigen Pegel aufweisen und umfasst Pulse, welche durch Wechsel zwischen dem hohen Pegel und dem niedrigen Pegel erzeugt werden. Wie unten näher erläutert, weisen diese Pulse eine variable Dichte auf. Das Pulssequenzsignal PM steuert die Wandlerschaltung 140 auf solche Weise, dass das Versorgungssignal nur dann an Versorgungsausgängen 181, 182 anliegt, wenn das Pulssequenzsignal PM den hohen Pegel aufweist. Dies kann erreicht werden, indem die Wandlerschaltung 140 deaktiviert wird, während Pulssequenzsignal PM den niedrigen Pegel aufweist.

Zur Erzeugung des Pulssequenzsignals PM umfasst die Dimmsteuerung 150 einen Sigma-Delta-Wandler 160. Über ein Eingangssignal DL des Sigma-Delta-Wandlers 160 kann ein Dimmlevel vorgegeben werden. Ein hoher Dimmlevel entspricht dabei einer hohen Helligkeit des Leuchtmittels 200, während ein niedriger Dimmlevel einer niedrigen Helligkeit des Leuchtmittels 200 entspricht. Bei dem dargestellten Beispiel handelt es sich bei dem Eingangssignal DL des Sigma-Delta-Wandlers 160 um ein digitales Signal mit einer Bittiefe von 16 Bit. Hieraus ergibt sich für das Dimmen des Leuchtmittels 200 eine Auflösung von 2¹⁶ Stufen, was einem Wertebereich des Dimmlevels von 0 bis 2¹⁶-1=65535 entspricht. Es versteht sich jedoch, dass auch die Verwendung niedrigerer oder sogar höherer Bittiefen möglich wäre. Weiterhin wäre es auch möglich den Dimmlevel über ein analoges Signal vorzugeben.

Der Sigma-Delta-Wandler 160 ist für einen zeitdiskreten Betrieb ausgestaltet und wird auf Basis eines zweiten Taktsignals CLK2 betrieben. Die Frequenz des zweiten Taktsignals CLK2 ist niedriger als die Frequenz des ersten Taktsignals CLK1 und kann beispielsweise im Bereich von 10kHz bis 500kHz liegen. Eine beispielhafte Implementierung des Sigma-Delta-Modulators 160 ist in Figur 2 dargestellt.

Wie in Figur 2 dargestellt, umfasst der Sigma-Delta-Modulator 160 ein erstes Addierglied 161, ein zweites Addierglied 162, ein Tiefpassfilter 163, ein Verzögerungsglied 164, einen Komparator 165 und ein Multiplizierglied 166, d.h. eine Verstärkungsstufe. Diese Komponenten können jeweils als digitale Signalverarbeitungselemente realisiert sein, so dass sich eine vollständig digitale Implementierung des Sigma-Delta-Modulators 160 ergibt, bei welcher auf Funktionen zur Analog-Digital-Wandlung und Funktionen zur Analog-Digital-Wandlung verzichtet werden kann.

Das Eingangssignal DL des Sigma-Delta-Modulators 160 ist dem ersten Addierglied 161 zugeführt, an welchem ein Rückkopplungssignal FB von dem Eingangssignal DL subtrahiert wird. Ein Ausgangssignal des ersten Addierglieds 161 entspricht somit einer Differenz des Eingangssignals DL und des Rückkopplungssignals FB. Das Ausgangssignal des ersten Addierglieds 161 ist dem zweiten Addierglied 162 zugeführt, an welchem ein Vorwärtskopplungssignal FF zu dem Ausgangssignal des ersten Addierglieds 161 addiert wird. Ein Ausgangssignal des zweiten Addierglieds 162 entspricht somit der Summe aus dem Ausgangssignal des ersten Addierglieds 161 und dem Vorwärtskopplungssignal FF. Das Ausgangssignal des zweiten Addierglieds 162 ist über das Tiefpassfilter 163 dem Verzögerungsglied 165 zugeführt. Ein Ausgangssignal des Verzögerungsglieds 164 ist dem Komparator 165 zugeführt und bildet weiterhin das Vorwärtskopplungssignal FF. Das zweite Addierglied 162 mit dem Vorwärtskopplungssignal, das Tiefpassfilter 163 und das Verzögerungsglied 165 wirken als Integrator für das Ausgangssignal des ersten Addierglieds 161. Der Komparator 165 erzeugt ein Ausgangssignal mit dem Wert 1, wenn das Ausgangssignal des Integrators größer als null ist und erzeugt sonst ein Ausgangssignal mit dem Wert 0. Das Ausgangssignal des Komparators 165 ist dem Multiplizierglied 166 zugeführt, dessen Ausgangssignal das Rückkopplungssignal FB bildet. Das Multiplizierglied 166 bewirkt eine Multiplikation mit einem Faktor, der an die Bittiefe des Eingangssignals DL angepasst ist. Insbesondere ist dieser Faktor derart gewählt, dass der Wert 1 am Ausgang des Komparators 165 auf den höchsten möglichen Wert des Eingangssignals DL skaliert wird. Bei dem dargestellten Beispiel beträgt dieser Faktor 2¹⁶-1. Hierdurch wird erreicht, dass für höhere Werte des Eingangssignals DL mit zunehmender Häufigkeit das Pulssequenzsignal PM mit dem hohen Pegel erzeugt wird, wohingegen für niedrigere Werte des Eingangssignals DL mit zunehmender Häufigkeit das Pulssequenzsignal PM mit dem niedrigen Pegel erzeugt wird. Somit entstehen in dem Pulssequenzsignal PM Pulse variabler Breite, deren zeitliche Dichte mit dem Wert des Eingangssignals abnimmt. Gemäß dem von dem Sigma-Delta-Modulator 160 erzeugten Pulssequenzsignal PM erfolgt die Pulsmodulation des Versorgungssignals somit als Pulsdichtemodulation.

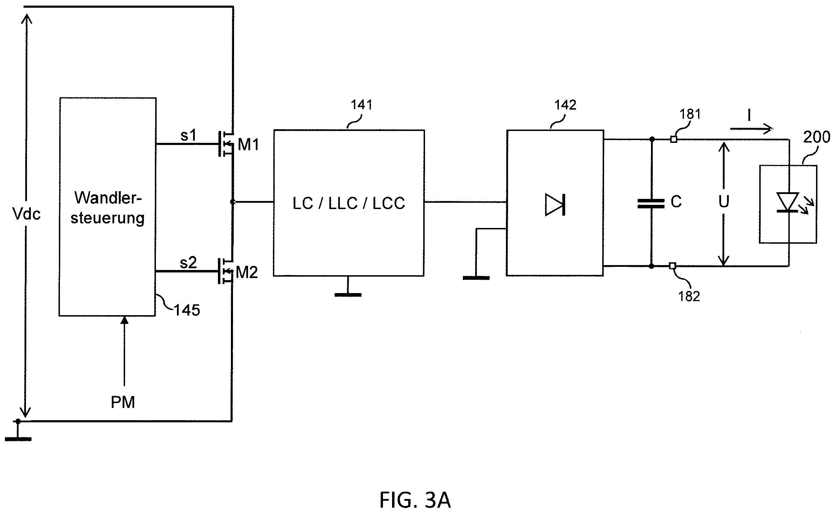

Figur 3A zeigt eine beispielhafte Implementierung der Wandlerschaltung 140. Bei der in Figur 3A gezeigten Implementierung ist die Wandlerschaltung 140 als LC-, LLC- oder LCC-Resonanzwandler ausgestaltet. Wie dargestellt, umfasst die Wandlerschaltung 140 in diesem Fall MOS-Transistoren M1, M2 (MOS: "Metal Oxide Semiconductor"), welche in einer Halbbrückenschaltung angeordnet sind. Die Steuerung der MOS-Transistoren M1, M2 erfolgt über Steuersignale s1, s2, die von einer Wandlersteuerung 145 erzeugt werden. Die Wandlersteuerung 145 kann z.B. durch einen Mikrocontroller implementiert sein. Die MOS-Transistoren M1, M2 dienen als Schalter, welche durch die Steuersignale s1, s2 zwischen einem geöffneten Zustand und einem geschlossenen Zustand umgeschaltet werden können. Dies geschieht durch Eigenresonanz der Wandlerschaltung 140 auf solche Weise, dass in einem bestimmten Taktzyklus des ersten Taktsignals der MOS-Transistor M1 in dem geöffneten Zustand ist, während der MOS-Transistor M2 in dem geschlossenen Zustand ist, wohingegen im nachfolgenden Taktzyklus der MOS-Transistor M1 in dem geschlossenen Zustand ist, während der MOS-Transistor M2 in dem geöffneten Zustand ist. Bei der in Figur 3A dargestellten Implementierung wird das erste Taktsignal CLK1 somit durch Eigenresonanz innerhalb der Wandlerschaltung 140 erzeugt.

Weiterhin umfasst die Wandlerschaltung ein LC-, LLC- oder LCC-Netzwerk 141, welches durch das Umschalten der MOS-Transistoren M1, M2 resonant angeregt wird. Weiterhin sind eine Gleichrichterstufe 142, z.B. basierend auf einer oder mehreren Dioden, sowie ein Filterkondensator C vorgesehen, welcher zusammenwirkend mit der Gleichrichterstufe 142 eine Gleichrichtung und Glättung eines von dem LC-, LLC- oder LCC-Netzwerk 141 an den Versorgungsausgängen 181, 182 erzeugten Versorgungssignals bewirkt.

Die Regelung des von der Wandlerschaltung 140 erzeugten Stroms I auf den vorgegebenen Wert kann durch einen gepulsten Betrieb der Wandlerschaltung 140 erfolgen. Der gepulste Betrieb kann insbesondere beinhalten, dass abhängig von einer Abweichung des Stromes I von dem vorgegebenen Strompegel die resonante Anregung des LC-, LLC- oder LCC-Netzwerks 141 zugelassen oder unterbunden wird.

Die Pulsmodulation des erzeugten Versorgungssignals wird dadurch erreicht, dass die Wandlersteuerung 145 die MOS-Transistoren M1, M2 darüber hinaus abhängig von dem Pulssequenzsignal PM ansteuert. Insbesondere können beide MOS-Transistoren M1, M2 in den geöffneten Zustand geschaltet werden, wenn das Pulssequenzsignal PM den niedrigen Pegel aufweist, so dass die resonante Anregung des LC-, LLC- oder LCC-Netzwerks 141 unterbleibt und der Strompegel des Versorgungssignals auf null absinkt. Alternativ könnte die resonante Anregung des LC-, LLC- oder LCC-Netzwerks 141 auch unterbunden werden, indem einer der MOS-Transistoren M1, M2 in dem geöffneten Zustand gehalten wird und der andere der MOS-Transistoren in dem geschlossenen Zustand gehalten wird.

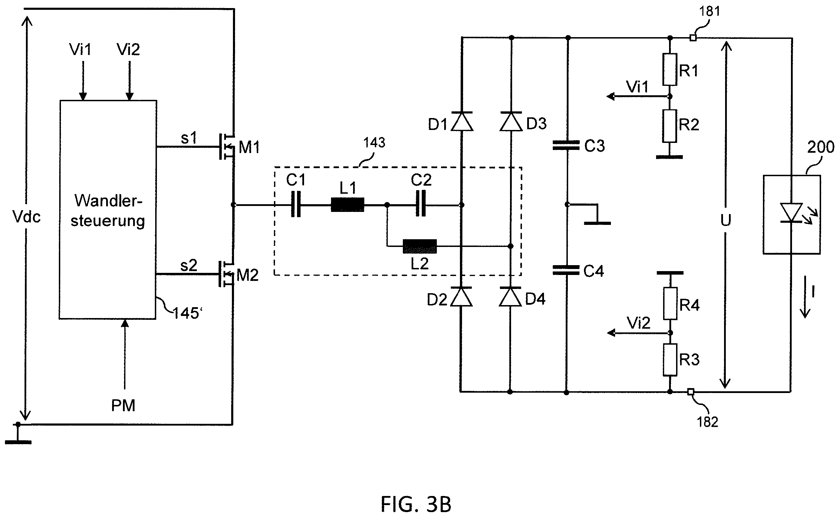

Figur 3B zeigt eine weitere beispielhafte Implementierung der Wandlerschaltung 140. Bei der in Figur 3B gezeigten Implementierung ist die Wandlerschaltung 140 als LLC-Resonanzwandler ausgestaltet. Ähnlich wie bei der Implementierung von Figur 3A, umfasst die Wandlerschaltung 140 in diesem Fall MOS-Transistoren M1, M2, welche in einer Halbbrückenschaltung angeordnet sind. Die Steuerung der MOS-Transistoren M1, M2 erfolgt über Steuersignale s1, s2, die von einer Wandlersteuerung 145` erzeugt werden. Die Wandlersteuerung 145` kann z.B. durch einen Mikrocontroller implementiert sein. Die MOS-Transistoren M1, M2 dienen als Schalter, welche durch die Steuersignale s1, s2 zwischen einem geöffneten Zustand und einem geschlossenen Zustand umgeschaltet werden können. Dies geschieht durch Eigenresonanz der Wandlerschaltung 140 auf solche Weise, dass in einem bestimmten Taktzyklus der MOS-Transistor M1 in dem geöffneten Zustand ist, während der MOS-Transistor M2 in dem geschlossenen Zustand ist, wohingegen im nachfolgenden Taktzyklus der MOS-Transistor M1 in dem geschlossenen Zustand ist, während der MOS-Transistor M2 in dem geöffneten Zustand ist. Bei der in Figur 3A dargestellten Implementierung wird das erste Taktsignal CLK1 somit durch Eigenresonanz innerhalb der Wandlerschaltung 140 erzeugt.

Weiterhin umfasst bei der Implementierung von Figur 3B die Wandlerschaltung 140 kapazitive Elemente C1, C2, C3, C4, z.B. in Form von Kondensatoren, und induktive Elemente L1, L2, z.B. in Form von Spulen, sowie Dioden D1, D2, D3, D4. Die kapazitiven Elemente C1, C2 und die induktiven Elemente L1, L2 bilden ein LLC-Netzwerk 143, welches durch das Umschalten der MOS-Transistoren M1, M2 resonant angeregt wird, um an den Versorgungsausgängen 181, 182 das Versorgungssignal mit dem vorgegebenen Strompegel zu erzeugen. Die Dioden D1, D2, D3, D4 bilden wiederum eine Brückenschaltung am Ausgang des LLC-Netzwerks 141 und bewirken zusammen mit den kapazitiven Elementen C3, C4 eine Gleichrichtung und Glättung des an den Versorgungsausgängen 181, 182 erzeugten Versorgungssignals.

Die Regelung des von der Wandlerschaltung 140 erzeugten Stroms I auf den vorgegebenen Wert kann durch einen gepulsten Betrieb der Wandlerschaltung 140 erfolgen. Der gepulste Betrieb kann insbesondere beinhalten, dass abhängig von einer Abweichung des Stromes I von dem vorgegebenen Strompegel die resonante Anregung des LLC-Netzwerks 143 zugelassen oder unterbunden wird. Alternativ oder zusätzlich kann die Regelung des von der Wandlerschaltung 140 erzeugten Stroms I auf den vorgegebenen Wert erfolgen, indem eine Schaltfrequenz der MOS-Transistoren M1, M2 abhängig von einer Abweichung des Stromes I von dem vorgegebenen Strompegel gesteuert wird. In diesem Fall kann anstelle der Erzeugung des ersten Taktsignals CLK1 durch Eigenresonanz das erste Taktsignal CLK1 mit einer steuerbaren Frequenz von einer Taktsignalquelle bereitgestellt werden und zur Steuerung der MOS-Transistoren M1, M2 genutzt werden. Um die Abweichung des Stromes I von dem vorgegebenen Strompegel zu erfassen können Shunt-Widerstände R1, R2 bzw. R3, R4 vorgesehen sein, über welche den Wert des Stromes I Spannungen Vi1, Vi2 gemessen werden können, die wiederum als Eingangssignale der Wandlersteuerung 145` genutzt werden können. Es versteht sich hierbei jedoch, dass dieser Regelmechanismus lediglich beispielhaft dargestellt ist und auch andere Mechanismen zur Regelung oder Nachführung des Strompegels auf den vorgegebenen Wert genutzt werden könnten.

Die Pulsmodulation des erzeugten Versorgungssignals wird bei der Implementierung von Figur 3B dadurch erreicht, dass die Wandlersteuerung 145` die MOS-Transistoren M1, M2 darüber hinaus abhängig von dem Pulssequenzsignal PM ansteuert. Insbesondere können beide MOS-Transistoren M1, M2 in den geöffneten Zustand geschaltet werden, wenn das Pulssequenzsignal PM den niedrigen Pegel aufweist, so dass die resonante Anregung des LLC-Netzwerks 143 unterbleibt und der Strompegel des Versorgungssignals auf null absinkt. Alternativ könnte die resonante Anregung des LLC-Netzwerks 143 auch unterbunden werden, indem einer der MOS-Transistoren M1, M2 in dem geöffneten Zustand gehalten wird und der andere der MOS-Transistoren in dem geschlossenen Zustand gehalten wird.

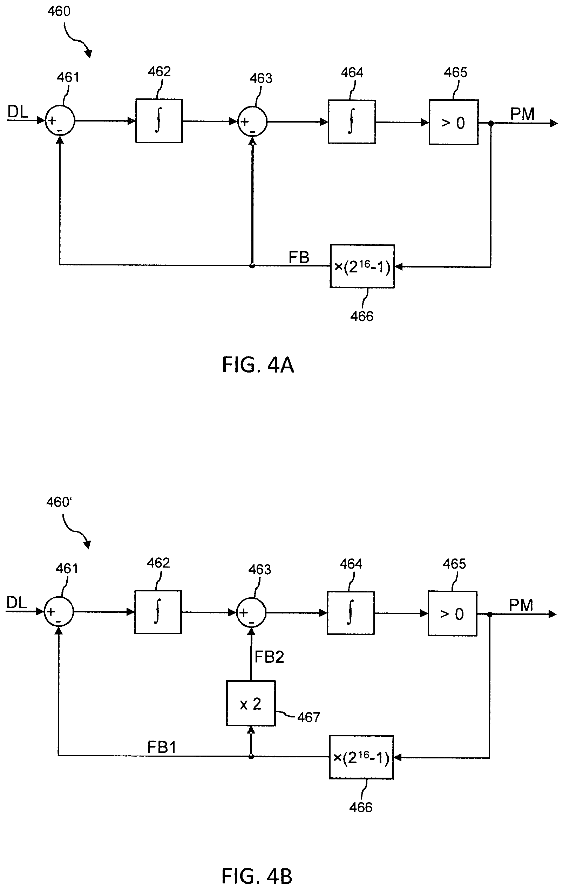

Figur 4A zeigt eine weitere beispielhafte Implementierung eines Sigma-Delta-Modulators 460, welche alternativ zu der Implementierung von in Figur 2 in der Dimmsteuerung 150 genutzt werden kann. Der Sigma-Delta-Modulator 460 ist mehrstufig, d.h. als Sigma-Delta-Modulator höherer Ordnung, ausgestaltet. Wie oben erwähnt, kann auch der Sigma-Delta-Modulator 460 für einen zeitdiskreten Betrieb ausgestaltet sein und wird auf Basis des zweiten Taktsignals CLK2 betrieben werden, wobei die Frequenz des zweiten Taktsignals CLK2 niedriger ist als die Frequenz des ersten Taktsignals CLK1 und im Bereich von 10kHz bis 500kHz liegen kann.

Wie in Figur 4A dargestellt, umfasst der Sigma-Delta-Modulator 160 ein erstes Addierglied 461, einen ersten Integrator 462, ein zweites Addierglied 463, einen zweiten Integrator 464, einen Komparator 465 und ein Multiplizierglied 466, d.h. eine Verstärkungsstufe. Diese Komponenten können jeweils als digitale Signalverarbeitungselemente realisiert sein, so dass sich eine vollständig digitale Implementierung des Sigma-Delta-Modulators 460 ergibt, bei welcher auf Funktionen zur Analog-Digital-Wandlung und Funktionen zur Analog-Digital-Wandlung verzichtet werden kann. Die Integratoren 462 und 463 können jeweils wie im Zusammenhang mit Figur 2 erläutert mittels eines Tiefpassfilters, eines Verzögerungsglieds und einer Vorwärtskopplungsschleife implementiert sein.

Das Eingangssignal DL des Sigma-Delta-Modulators 460 ist dem ersten Addierglied 461 zugeführt, an welchem ein Rückkopplungssignal FB von dem Eingangssignal DL subtrahiert wird. Ein Ausgangssignal des ersten Addierglieds 461 entspricht somit einer Differenz des Eingangssignals DL und des Rückkopplungssignals FB. Ein Ausgangssignal des ersten Addierglieds 461 ist dem ersten Integrator 462 zugeführt. Ein Ausgangssignal des ersten Integrators 462 ist dem zweiten Addierglied 463 zugeführt, an welchem das Rückkopplungssignal FB von dem Ausgangssignal des ersten Integrators 462 subtrahiert wird. Ein Ausgangssignal des zweiten Addierglieds 463 entspricht somit einer Differenz des Ausgangssignals des ersten Integrators 462 und des Rückkopplungssignals FB. Ein Ausgangssignal des ersten Integrators 462 ist dem Komparator 465. Der Komparator 465 erzeugt ein Ausgangssignal mit dem Wert 1, wenn das Ausgangssignal des zweiten Integrators 464 größer als null ist und erzeugt sonst ein Ausgangssignal mit dem Wert 0. Das Ausgangssignal des Komparators 465 ist dem Multiplizierglied 466 zugeführt, dessen Ausgangssignal das Rücckopplungssignal FB bildet. Wie im Zusammenhang mit Figur 2 erläutert bewirkt Multiplizierglied 466 eine Multiplikation mit einem Faktor, der an die Bittiefe des Eingangssignals DL angepasst ist. Auch bei dem Sigma-Delta-Modulator 460 ist dieser Faktor derart gewählt, dass der Wert 1 am Ausgang des Komparators 465 auf den höchsten möglichen Wert des Eingangssignals DL skaliert wird. Bei dem dargestellten Beispiel beträgt dieser Faktor 2¹⁶-1. Hierdurch wird erreicht, dass für höhere Werte des Eingangssignals DL mit zunehmender Häufigkeit das Pulssequenzsignal PM mit dem hohen Pegel erzeugt wird, wohingegen für niedrigere Werte des Eingangssignals DL mit zunehmender Häufigkeit das Pulssequenzsignal PM mit dem niedrigen Pegel erzeugt wird. Somit entstehen in dem Pulssequenzsignal PM Pulse variabler Breite, deren zeitliche Dichte mit dem Wert des Eingangssignals abnimmt. Gemäß dem von dem Sigma-Delta-Modulator 460 erzeugten Pulssequenzsignal PM erfolgt die Pulsmodulation des Versorgungssignals somit als Pulsdichtemodulation. Bei dem Sigma-Delta-Modulator 460 können das erste Addierglied 461 und der erste Integrator 462 als eine erste Stufe des Sigma-Delta-Modulators 460 angesehen werden, während das zweite Addierglied 463 und der zweite Integrator 464 als eine zweite Stufe des Sigma-Delta-Modulators 460 angesehen werden können, in welcher mittels des zweiten Addierglieds 463 eine zusätzliche Rückkopplungsschleife ausgebildet ist.

Anhand von Simulationen hat sich gezeigt, dass durch die zusätzliche Rückkopplungsschleife, d.h. durch die Ausgestaltung als Sigma-Delta-Modulator zweiter Ordnung, eine gegenüber der Implementierung von Figur 2 gleichmäßiger spektrale Verteilung von Frequenzen in dem Pulssequenzsignal PM erreicht werden kann, so dass eine verbesserte Vermeidung von Störungen insbesondere im Bereich niedriger Frequenzen ermöglicht wird.

Figur 4B zeigt eine weitere beispielhafte Implementierung eines Sigma-Delta-Modulators 460`, welche alternativ zu der Implementierung von in Figur 2 in der Dimmsteuerung 150 genutzt werden kann. Der Sigma-Delta-Modulator 460` ist ähnlich wie der Sigma-Delta-Modulator 460 aufgebaut, d.h. mehrstufig ausgestaltet. Wie oben erwähnt, kann auch der Sigma-Delta-Modulator 460' für einen zeitdiskreten Betrieb ausgestaltet sein und wird auf Basis des zweiten Taktsignals CLK2 betrieben werden, wobei die Frequenz des zweiten Taktsignals CLK2 niedriger ist als die Frequenz des ersten Taktsignals CLK1 und im Bereich von 10kHz bis 500kHz liegen kann.

Wie in Figur 4B dargestellt, unterscheidet sich der Sigma-Delta-Modulator 460' von dem Sigma-Delta-Modulator 460 dahingehend, dass in der zusätzlichen Rückkopplungsschleife ein weiteres Multiplizierglied 467 vorgesehen ist, welchem das Ausgangssignal des Multiplizierglieds 466 zugeführt ist. Bei dem dargestellten Beispiel bewirkt das weitere Multiplizierglied 467 eine Multiplikation mit einem Faktor 2. Es versteht sich jedoch, dass dieser Faktor auch anders gewählt werden kann, um Eigenschaften des von dem Sigma-Delta-Modulator 460' erzeugten Pulssequenzsignals PM anzupassen. Wie dargestellt, erzeugt bei dem Sigma-Delta-Modulator 460`das Multiplizierglied 466 ein erstes Rückkopplungssignal FB1, welches an dem ersten Addierglied 461 von dem Eingangssignal DL subtrahiert wird, während das weitere Multiplizierglied 467 ein zweites Rückkopplungssignal FB2 erzeugt, welches an dem zweiten Addierglied 463 von dem Ausgangssignal des ersten Integrators 462 subtrahiert wird.

Anhand von Simulationen hat sich gezeigt, dass durch die verschiedenen Rückkopplungssignale FB1, FB2 eine gegenüber der Implementierung von Figur 4B weiter verbesserte spektrale Verteilung von Frequenzen in dem Pulssequenzsignal PM, mit einer geringeren spektralen Leistungsdichte bei niedrigen Frequenzen, erreicht werden kann, so dass eine verbesserte Vermeidung von Störungen insbesondere im Bereich niedriger Frequenzen ermöglicht wird.

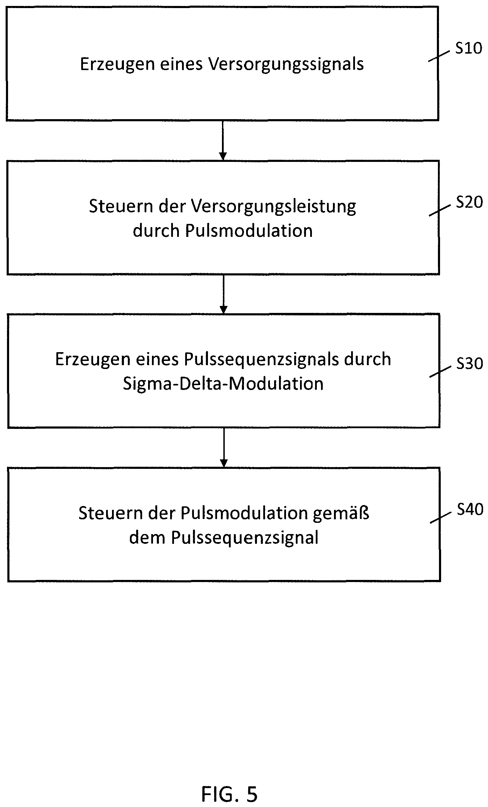

Figur 5 veranschaulicht ein beispielhaftes Verfahren zum, gemäß welchem ein elektrischer Verbraucher, z.B. das oben genannte LED-Leuchtmittel 200, versorgt werden kann. Das Verfahren von Figur 5 wird von der im Vorangegangenen beschriebenen Versorgungsschaltung 100 ausgeführt.

Bei Schritt S10 wird ein Versorgungssignal für den elektrischen Verbraucher erzeugt. Dies geschieht durch Umschalten einer Wandlerschaltung zwischen verschiedenen Zuständen. Bei der Wandlerschaltung handelt es sich um einen LC-, LLC- oder LCC-Resonanzwandler wie für die oben genannte Wandlerschaltung 140 anhand von Figur 3A oder 3B erläutert. Das Versorgungssignal kann als Gleichstromsignal mit vorgegebenem Strompegel erzeugt werden. Das Umschalten zwischen den verschiedenen Zuständen erfolgt mit einer ersten Frequenz, die im Bereich von 1MHz oder mehr liegen kann. Eine Verwendung niedrigerer Frequenzen, z.B. im Bereich von einigen 100kHz ist jedoch ebenfalls möglich.

Bei Schritt S20 wird eine Versorgungsleistung der elektrischen Last durch Pulsmodulation des Versorgungssignals gesteuert. Wenn die elektrische Last ein Leuchtmittel umfasst, kann diese Steuerung insbesondere einem Dimmen des Leuchtmittels dienen.

Bei Schritt S30 wird ein Pulssequenzsignal durch Sigma-Delta-Modulation eines Eingangssignals erzeugt, beispielsweise wie oben für das Eingangssignal DL und das Pulssequenzsignal PM erläutert. Das Eingangssignal gibt dabei einen Zielwert für die Versorgungsleistung des elektrischen Verbrauchers vor, z.B. in Form eines Dimmlevels. Das Eingangssignal kann ein digitales Signal sein. Das digitale Eingangssignal ist vorzugsweise hochauflösend, z.B. indem es eine Steuerung Versorgungsleistung mit mehr als 1000 Stufen ermöglicht.

Die Sigma-Delta-Modulation kann mittels eines Sigma-Delta-Modulators erster Ordnung, z.B. wie anhand von Figur 2 erläutert, oder mittels eines Sigma-Delta-Modulators höherer Ordnung, z.B. ein Sigma-Delta-Modulator zweiter Ordnung wie anhand von Figur 4A und 4B erläutert, durchgeführt werden. Das Eingangssignal ist ein digitales Signal. Eine Rücckopplungsschleife des Sigma-Delta-Modulators weist eine Verstärkung auf, welche an eine Bittiefe des Eingangssignals angepasst ist, z.B. wie im Zusammenhang mit den Multipliziergliedern 166 und 466 erläutert.

Bei Schritt S40 wird die Pulsmodulation gemäß dem bei Schritt S30 erzeugten Pulssequenzsignal gesteuert. Dies kann beispielsweise beinhalten, dass das Versorgungssignal nur dann erzeugt bzw. dem elektrischen Verbraucher zugeführt wird, wenn das Pulssequenzsignal einen bestimmten von zwei möglichen Pegeln aufweist, z.B. einen hohen Pegel.

Es versteht sich, dass bei den dargestellten Konzepten vielfältige Modifikationen möglich sind. So können beispielsweise die dargestellten Konzepte auch zur Versorgung von anderen Verbrauchern als LED-Leuchtmittel, z.B. andere Arten von Leuchtmittel oder Elektromotoren, genutzt werden. Darüber hinaus, kann das Versorgungssignal auf vielfältige Weise erzeugt werden, ohne Beschränkung auf die oben genannten Wandlerschaltungen. Darüber hinaus versteht es sich, dass auch abweichende Implementierungen von Sigma-Delta-Modulatoren genutzt werden könnten, z.B. Sigma-Delta-Modulatoren dritter oder höherer Ordnung, analoge Sigma-Delta-Modulatoren oder gemischt digital und analoge Sigma-Delta-Modulatoren.

## Patentansprüche

1. Versorgungsschaltung (100), umfassend:
- eine Wandlerschaltung (140) zur Erzeugung eines Versorgungsignals (I, U) für eine elektrische Last (200),
wobei die Wandlerschaltung (140) ein LC-, LLC- oder LCC-Resonanzwandler mit einem Netzwerk (141) und einer Wandlersteuerung (145) ist und MOS-Transistoren (M1, M2) aufweist, welche in einer Halbbrückenschaltung angeordnet sind, wobei die MOS-Transistoren (M1, M2) durch Steuersignale (S1, S2) der Wandlersteuerung (145) auf Basis eines ersten Takts gesteuert sind;
**dadurch gekennzeichnet, dass** die Versorgungsschaltung (100) weiterhin umfasst:
- eine Steuerschaltung (150) zur Steuerung einer Versorgungsleistung der elektrischen Last (200) durch Pulsmodulation des von der Wandlerschaltung (140) erzeugten Versorgungssignals (I, U),
wobei die Steuerschaltung (150) einen Sigma-Delta-Modulator (160; 460; 460`) umfasst, welcher dazu ausgestaltet ist, abhängig von einem digitalen Eingangssignal (DL), welches einen Zielwert für die Versorgungsleistung vorgibt, ein Pulssequenzsignal (PM) auf Basis eines zweiten Takts zu erzeugen, und
wobei die Steuerschaltung (150) die MOS-Transistoren (M1, M2) der Wandlerschaltung (140) darüber hinaus in Abhängigkeit von dem erzeugten Pulssequenzsignal (PM) mittels der Wandlersteuerung (145) derart ansteuert, dass bei niedrigen Pegeln des Pulssequenzsignals (PM) eine resonante Anregung des Netzwerks unterbleibt, und
wobei eine Rückkopplungsschleife des Sigma-Delta-Modulators (160; 460; 460`) eine Verstärkung aufweist, welche an eine Bittiefe des Eingangssignals (DL) angepasst ist.

2. Versorgungsschaltung (100) nach Anspruch 1,
wobei das zweite Taktsignal (CLK2) eine niedrigere Frequenz als das erste Taktsignal (CLK1) aufweist.

3. Versorgungsschaltung (100) nach Anspruch 2,
wobei die Frequenz des zweiten Taktsignals (CLK2) im Bereich von 10kHz bis 500kHz liegt.

4. Versorgungsschaltung (100) nach einem der vorhergehenden Ansprüche,
wobei die Frequenz des ersten Taktsignals (140) 1MHz oder mehr ist.

5. Versorgungsschaltung (100) nach einem der vorhergehenden Ansprüche,
wobei der Sigma-Delta-Modulator (460; 460`) mehrstufig ist.

6. Versorgungsschaltung (100) nach einem der vorhergehenden Ansprüche,
wobei die elektrische Last (200) ein Leuchtmittel umfasst und die Steuerung der Versorgungsleistung einem Dimmen des Leuchtmittels dient.

7. Verfahren zur Versorgung einer elektrischen Last (200) mittels einer Versorgungsschaltung nach einem der Ansprüche 1 bis 6, wobei das Verfahren umfasst:
- Erzeugen des Versorgungssignals (I, U) für die elektrische Last aus der Gleichspannung auf Basis des ersten Takts mittels der Wandlerschaltung (140);
- Erzeugen des Pulssequenzsignals (PM) auf Basis des zweiten Takts durch Sigma-Delta-Modulation des digitalen Eingangssignals mittels des Sigma-Delta Modulators welches den Zielwert für die Versorgungsleistung vorgibt; und
- Steuern der MOS-Transistoren (M1, M2) auf Basis des zweiten Takts gemäß dem der Wandlersteuerung (145) zugeführten Pulssequenzsignal (PM) derart, dass bei niedrigen Pegeln des Pulssequenzsignals (PM) die resonante Anregung des Netzwerks unterbleibt; und
- Steuern der Versorgungsleistung der elektrischen Last (200) durch die Pulsmodulation des Versorgungssignals (I, U).

8. Verfahren nach Anspruch 7,
wobei die elektrische Last (200) ein Leuchtmittel umfasst und die Steuerung der Versorgungsleistung ein Dimmen des Leuchtmittels bewirkt.

## Claims

1. Supply circuit (100), comprising:
- a converter circuit (140) for generating a supply signal (I, U) for an electrical load (200),
wherein the converter circuit (140) is an LC, LLC, or LCC resonant converter having a network (141) and a converter controller (145) and has MOS transistors (M1, M2) which are arranged in a half-bridge circuit, wherein the MOS transistors (M1, M2) are controlled by control signals (S1, S2) of the converter controller (145) on the basis of a first clock;
**characterized in that** the supply circuit (100) further comprises:
- a control circuit (150) for controlling a supply power of the electrical load (200) by pulse modulation of the supply signal (I, U) generated by the converter circuit (140),
wherein the control circuit (150) comprises a sigma-delta modulator (160; 460; 460') which is designed to generate a pulse sequence signal (PM) on the basis of a second clock, depending on a digital input signal (DL) which specifies a target value for the supply power, and
wherein the control circuit (150) also controls the MOS transistors (M1, M2) of the converter circuit (140) depending on the generated pulse sequence signal (PM) by means of the converter controller (145) such that, at low levels of the pulse sequence signal (PM), resonant excitation of the network is stopped, and
wherein a feedback loop of the sigma-delta modulator (160; 460; 460') has a gain that is adapted to a bit depth of the input signal (DL).

2. Supply circuit (100) according to claim 1,
wherein the second clock signal (CLK2) has a lower frequency than the first clock signal (CLK1).

3. Supply circuit (100) according to claim 2,
wherein the frequency of the second clock signal (CLK2) is in the range of 10 kHz to 500 kHz.

4. Supply circuit (100) according to any of the preceding claims, wherein the frequency of the first clock signal (140) is 1 MHz or more.

5. Supply circuit (100) according to any of the preceding claims, wherein the sigma-delta modulator (460; 460') is multi-stage.

6. Supply circuit (100) according to any of the preceding claims, wherein the electrical load (200) comprises a lamp and the control of the supply power is intended to dim the lamp.

7. Method for supplying an electrical load (200) by means of a supply circuit according to any of claims 1 to 6, wherein the method comprises:
- generating the supply signal (I, U) for the electrical load from the DC voltage on the basis of the first clock by means of the converter circuit (140);
- generating the pulse sequence signal (PM) on the basis of the second clock by sigma-delta modulation of the digital input signal by means of the sigma-delta modulator which specifies the target value for the supply power, and
- controlling the MOS transistors (M1, M2) on the basis of the second clock in accordance with the pulse sequence signal (PM) supplied to the converter controller (145) such that at low levels of the pulse sequence signal (PM), resonant excitation of the network is stopped; and
- controlling the supply power of the electrical load (200) by the pulse modulation of the supply signal (I, U).

8. Method according to claim 7,
wherein the electrical load (200) comprises a lamp and the control of the supply power causes dimming of the lamp.

## Revendications

1. Circuit d'alimentation (100), comprenant :
- un circuit de convertisseur (140) permettant de générer un signal d'alimentation (I, U) pour une charge électrique (200),
dans lequel le circuit de convertisseur (140) est un convertisseur résonant LC, LLC ou LCC comportant un réseau (141) et une commande de convertisseur (145) et présente des transistors MOS (M1, M2) qui sont disposés dans un circuit en demi-pont, dans lequel les transistors MOS (M1, M2) sont commandés par des signaux de commande (S1, S2) de la commande de convertisseur (145) sur la base d'une première horloge ;
**caractérisé en ce que** le circuit d'alimentation (100) comprend en outre :
- un circuit de commande (150) permettant de commander une puissance d'alimentation de la charge électrique (200) par modulation d'impulsions du signal d'alimentation (I, U) généré par le circuit de convertisseur (140),
dans lequel le circuit de commande (150) comprend un modulateur sigma-delta (160 ; 460 ; 460`) qui est configuré pour, en fonction d'un signal d'entrée (DL) numérique, lequel prédéfinit une valeur cible pour la puissance d'alimentation, générer un signal de séquence d'impulsions (PM) sur la base d'une seconde horloge, et
dans lequel le circuit de commande (150) commande les transistors MOS (M1, M2) du circuit de convertisseur (140) en outre en fonction du signal de séquence d'impulsions (PM) généré au moyen de la commande de convertisseur (145), de telle sorte qu'une excitation résonante du réseau est évitée en cas de faibles niveaux du signal de séquence d'impulsions (PM), et
dans lequel une boucle de rétroaction du modulateur sigma-delta (160 ; 460 ; 460`) présente un gain qui est adapté à une profondeur de bits du signal d'entrée (DL).

2. Circuit d'alimentation (100) selon la revendication 1,
dans lequel le second signal d'horloge (CLK2) présente une fréquence inférieure à celle du premier signal d'horloge (CLK1).

3. Circuit d'alimentation (100) selon la revendication 2,
dans lequel la fréquence du second signal d'horloge (CLK2) se trouve dans la plage allant de 10 kHz à 500 kHz.

4. Circuit d'alimentation (100) selon l'une des revendications précédentes, dans lequel la fréquence du premier signal d'horloge (140) est de 1 MHz ou plus.

5. Circuit d'alimentation (100) selon l'une des revendications précédentes, dans lequel le modulateur sigma-delta (460 ; 460`) est à plusieurs étages.

6. Circuit d'alimentation (100) selon l'une des revendications précédentes, dans lequel la charge électrique (200) comprend une source lumineuse et la commande de la puissance d'alimentation sert à faire varier l'intensité de la source lumineuse.

7. Procédé permettant l'alimentation d'une charge électrique (200) au moyen d'un circuit d'alimentation selon l'une des revendications 1 à 6, dans lequel le procédé comprend :
- la génération du signal d'alimentation (I, U) pour la charge électrique à partir de la tension continue sur la base de la première horloge au moyen du circuit de convertisseur (140) ;
- la génération du signal de séquence d'impulsions (PM) sur la base de la seconde horloge par modulation sigma-delta du signal d'entrée numérique au moyen du modulateur sigma-delta qui prédéfinit la valeur cible pour la puissance d'alimentation ; et
- la commande des transistors MOS (M1, M2) sur la base de la seconde horloge conformément au signal de séquence d'impulsions (PM) amené à la commande de convertisseur (145), de telle sorte que l'excitation résonante du réseau est évitée en cas de faibles niveaux du signal de séquence d'impulsions (PM) ; et
- la commande de la puissance d'alimentation de la charge électrique (200) par la modulation d'impulsions du signal d'alimentation (I, U).

8. Procédé selon la revendication 7,
dans lequel la charge électrique (200) comprend une source lumineuse et la commande de la puissance d'alimentation entraîne une variation de l'intensité de la source lumineuse.
